# EUROPÄISCHE PATENTSCHRIFT

(11) **EP 3 426 011 B1**
(45) Veröffentlichungstag und Bekanntmachung des Hinweises auf die Patenterteilung: **16.02.2022**
(21) Anmeldenummer: 18181504.4
(22) Anmeldetag: 03.07.2018
(51) Int. Cl.: H05K 5/00

(54) **ELEKTRONIKEINHEIT FÜR EINEN SENSOR, FAHRZEUG SOWIE HERSTELLVERFAHREN ZUM HERSTELLEN EINER ELEKTRONIKEINHEIT**
ELECTRONIC UNIT FOR A SENSOR, VEHICLE AND METHOD OF MANUFACTURING AN ELECTRONIC UNIT
UNITÉ ÉLECTRONIQUE POUR UN CAPTEUR, VÉHICULE AINSI QUE PROCÉDÉ DE FABRICATION D'UNE UNIT É ÉLECTRONIQUE

(30) Priorität: 05.07.2017 DE 102017115047
(43) Veröffentlichungstag der Anmeldung: 09.01.2019
(73) Patentinhaber: Huf Hülsbeck & Fürst GmbH & Co. KG, 42551 Velbert (DE)
(72) Erfinder: Schindler, Mirko, 42549 Velbert (DE); Witte, Martin, 48683 Ahaus (DE)
(74) Vertreter: Patentanwälte Bals & Vogel

(56) Entgegenhaltungen:
- EP-A1- 1 689 058
- WO-A1-2015/028254
- US-A- 6 068 491

## Beschreibung

Die Erfindung betrifft eine Elektronikeinheit für einen Sensor für ein Fahrzeug gemäß dem Oberbegriff des Anspruchs 1, ein Fahrzeug sowie ein Herstellverfahren zum Herstellen einer Elektronikeinheit für einen Sensor für ein Fahrzeug.

Es ist aus dem Stand der Technik bekannt, dass Sensoren zur Verbindung mit einer Fahrzeugelektronik an Elektronikeinheiten angeschlossen werden, welche eine Kommunikation der Sensoren mit dem Fahrzeug gewährleisten können. Dafür sind üblicherweise Leiterplatten mit entsprechenden Schaltungen in der Elektronikeinheit verbaut, um bspw. eine Kommunikation des Sensors mit einem Bussystems des Fahrzeugs zu gewährleisten.

Dabei ist es bekannt, die Anschlüsse für den Sensor und für das Fahrzeug nebeneinander anzuordnen, wobei die Leiterplatte in einem rückseitig geschlossenen Gehäuse angeordnet ist. Vorderseitig wird bei der Montage entsprechend die Leiterplatte in den Gehäuseteil eingeschoben und anschließend wird ein Adapter aufgesetzt, wobei Adapter und Gehäuse entsprechend mediendicht verschlossen werden. Die Montage der Einzelkomponenten ist dabei jedoch häufig sehr aufwendig. So ist ein solches Gehäuse meist schlecht zugänglich, sodass sich die Montage der Leiterplatte im Gehäuse ebenfalls aufwendig gestaltet. Ferner wird durch eine derartige Ausgestaltung die Baubreite im Wesentlichen durch die doppelte Breite eines entsprechend anzuschließenden Steckers des Sensor bzw. des Fahrzeugs bestimmt. Insbesondere in Fahrzeugen ist zur Verfügung stehender Bauraum jedoch stark begrenzt, sodass es wünschenswert ist, auch die Baubreite derartiger Elektronikeinheiten zu reduzieren. Die Druckschrift EP1689058 A1 betrifft ein Steuermodul (100), umfassend eine automatische Übertragungskontrolleinheit (10) sowie eine Verbindungseinheit (20) zur Herstellung einer Verbindung der Übertragungskontrolleinheit (10) mit den Verbindungselementen (28). Das Steuermodul (100) weist ferner eine Abdeckung (30) und eine Basis (40) auf, zwischen denen die Übertragungskontrolleinheit (10) und die Verbindungseinheit (20) angeordnet sind.

Es ist daher eine Aufgabe der vorliegenden Erfindung, voranstehende aus dem Stand der Technik bekannte Nachteile zumindest teilweise zu beheben. Insbesondere ist eine Aufgabe der vorliegenden Erfindung eine Elektronikeinheit bereit zu stellen, welche einfach in der Herstellung, insbesondere in der Montage, ist, eine geringe Anzahl an Bauteilen aufweist und/oder eine verbesserte Kommunikation zwischen Fahrzeug und Sensor ermöglicht.

Die voranstehende Aufgabe wird gelöst durch eine Elektronikeinheit mit den Merkmalen des Anspruchs 1, ein Fahrzeug mit den Merkmalen des abhängigen Anspruchs 11 sowie ein Herstellverfahren zum Herstellen einer Elektronikeinheit mit den Merkmalen des Anspruchs 12.

Weitere Merkmale und Details der Erfindung ergeben sich aus den Unteransprüchen, der Beschreibung und der Zeichnungen. Dabei gelten Merkmale und Details, die Zusammenhand mit der erfindungsgemäßen Elektronikeinheit beschrieben worden sind, selbstverständlich auch im Zusammenhang mit dem erfindungsgemäßen Fahrzeug und/oder dem erfindungsgemäßen Herstellverfahren und jeweils umgekehrt, sodass bezüglich der Offenbarung zu den einzelnen Erfindungsaspekten stets wechselseitig Bezug genommen wird bzw. werden kann.

Erfindungsgemäß weist die Elektronikeinheit für einen Sensor, insbesondere einen Fußschalter, für ein Fahrzeug einen ersten Anschlussbereich zum Verbinden der Elektronikeinheit mit dem Fahrzeug und einen zweiten Anschlussbereich zum Verbinden der Elektronikeinheit mit dem Sensor auf. Ferner weist die Elektronikeinheit ein Gehäuse und eine Leiterplatte auf. Die Leiterplatte ist in einer Kavität des Gehäuses angeordnet. Weiterhin ist die Leiterplatte zumindest teilweise zwischen dem ersten Anschlussbereich und dem zweiten Anschlussbereich angeordnet.

Um den Sensor betreiben zu können, kann der Sensor über die Elektronikeinheit an das Fahrzeug angeschlossen werden. Bei dem Sensor kann es sich insbesondere um einen Fußschalter handeln. Unter einem Fußschalter kann erfindungsgemäß ein Erfassungsmittel verstanden werden, welcher auf eine Bewegung eines Körperteils insbesondere eines Fußes, reagieren kann. So kann bspw. vorgesehen sein, dass die Elektronikeinheit mit einem Passive-Entry System eingesetzt wird, wobei ein ID-Geber, den der Benutzer mit sich trägt, sich gegenüber dem Fahrzeug identifiziert und somit eine Schließanlage zur Öffnung freigibt. Dabei kann die eigentliche Entriegelungs- und/oder Öffnungsbewegung einer Tür oder einer Klappe des Fahrzeugs vorzugsweise durch Betätigung des Sensors, insbesondere des Fußschalters, auslösbar sein. Dazu kann der Fußschalter in einem Stoßfänger oder in einer Seitentür des Fahrzeugs angeordnet sein. Durch das Gehäuse wird vorzugsweise die Leiterplatte zumindest teilweise gegenüber Umweltbedingungen geschützt. Vorzugsweise kann die Kavität gegen Spritzwasser und/oder Feuchtigkeit abgedichtet sein. Insbesondere kann die Kavität durch das Gehäuse mediendicht verschlossen sein. Dadurch kann die Leiterplatte auch bei widrigen Umwelt- und/oder Straßenbedingungen zuverlässig geschützt sein. Unter der Leiterplatte kann vorzugsweise eine Platine verstanden werden, welche unterschiedliche Elektronikbauelemente aufweist. So können bspw. Leiterbahnen auf die Leiterplatte aufgedruckt sein und dadurch zumindest einen Schaltungsbereich, bevorzugt mehrere Schaltungsbereiche, ausbilden. Durch den ersten Anschlussbereich ist ferner die Leiterplatte mit dem Fahrzeug verbindbar und durch den zweiten Anschlussbereich ist die Leiterplatte mit dem Sensor verbindbar. So kann vorzugsweise die Leiterplatte und/oder der erste Anschlussbereich dazu ausgebildet sein, im Bereich des ersten Anschlussbereichs an das Fahrzeug, insbesondere eine Spannungsquelle des Fahrzeugs, angeschlossen zu werden. Insbesondere kann der erste Anschlussbereich dazu ausgelegt sein, mit einem Bus des Fahrzeuges verbunden zu werden. Dadurch kann eine effiziente Datenkommunikation und/oder eine Energieversorgung realisierbar sein. Der Anschlussbereich kann elektrische Kontaktbereiche aufweisen, durch welche die Verbindung der Elektronikeinheit, insbesondere der Leiterplatte, mit dem Fahrzeug bzw. dem Sensor herstellbar sein kann. Die Kontaktbereiche können z.B. Klemmen zur Aufnahme eines Steckers des Sensors bzw. des Fahrzeugs aufweisen. Ferner kann vorzugsweise die Leiterplatte und/oder der zweite Anschlussbereich dazu ausgebildet sein, Messsignale des Sensors aufzunehmen und/oder zu verarbeiten. Somit kann bspw. der Sensor mit einer Spannung betrieben werden, welche sich von der Spannung unterscheidet, welche das Fahrzeug am ersten Anschlussbereich zur Verfügung stellen kann. Dazu kann die Leiterplatte vorzugsweise einen Spannungsregler aufweisen. Ferner ist es denkbar, dass die Leiterplatte einen Mikrocontroller für eine Messauswertung von Messdaten des Sensors ausweist. Insbesondere kann die Leiterplatte dazu ausgebildet sein, ein Messverfahren zur Analyse von Messdaten des Sensors durchzuführen. Insbesondere weist die Leiterplatte daher eine erste Seite und eine zweite Seite auf, wobei der erste Anschlussbereich an der ersten Seite vorgesehen ist und der zweite Anschlussbereich an der zweiten Seite. Vorzugsweise kann der erste Anschlussbereich an einer dem zweiten Anschlussbereich gegenüberliegenden Seite der Leiterplatte angeordnet sein. Dabei können die Anschlussbereiche bevorzugt parallel zueinander orientiert sein. So kann die Leiterplatte bspw. einen rechteckigen Querschnitt aufweisen, wobei der erste Anschlussbereich gegenüber dem zweiten Anschlussbereich angeordnet ist. Insbesondere ist die Leiterplatte räumlich zwischen dem ersten Anschlussbereich und dem zweiten Anschlussbereich angeordnet. Dabei kann vorgesehen sein, dass der erste Anschlussbereich und der zweite Anschlussbereich in einer Ebene liegen oder in einer Ebene versetzt zueinander angeordnet sind. Weiterhin ist es denkbar, dass der erste Anschlussbereich einen Winkel zur Leiterplatte und/oder zum zweiten Anschlussbereich aufweist.

Dadurch, dass die Leiterplatte zwischen dem ersten und dem zweiten Anschlussbereich angeordnet ist, kann in einfacher Art und Weise insbesondere gewährleistet werden, dass der Fahrzeuganschluss vom Sensoranschluss entfernt ist. So kann der Sensor ein hochempfindliches Messsystem aufweisen, welches durch eine Masseleitung des Fahrzeuganschlusses beeinflussbar sein kann. Dies wiederum kann somit schädlich für die Messergebnisse sein und zu Ungenauigkeiten führen. Darüber hinaus wird durch eine derartige Anordnung gewährleistet, dass eine Baugröße, insbesondere die Baubreite, reduziert ist. Insbesondere kann somit die Elektronikeinheit deutlich schmaler ausgestaltet werden als dies bspw. der Fall ist, wenn der erste Anschlussbereich direkt neben dem zweiten Anschlussbereich angeordnet ist. Insbesondere in Stoßfängern von Kraftfahrzeugen und/oder in Seitentüren von Kraftfahrzeugen ist dieser Bauraum durch weitere Bauteile und/oder Befestigungsschnittstellen des jeweiligen Fahrzugbauteils äußerst begrenzt. In Schiebetüren kann bspw. Bauraum durch verstellbare Fenster und deren Antrieb, Öffnungs- und Schließmechanismen der Türen sowie die Innenauskleidung des Fahrzeugs begrenzt sein. Darüber hinaus liegt eine Spannungsquelle bzw. das Fahrzeugsteuergerät häufig im Frontbereich des Fahrzeuges, während der Sensor in einem hinteren Bereich des Fahrzeuges das Messfeld aufspannen soll. Somit kann die Elektronikeinheit zwischen Fahrzeuganschluss und Sensor angeordnet werden, sodass die Leiterplatte einen Teil des Weges zwischen Sensor und Fahrzeuganschluss ausbilden kann, sodass eine Verlegung der Anschlüsse deutlich vereinfacht sein kann.

Im Rahmen der Erfindung ist ferner denkbar, dass die Kavität des Gehäuses zumindest teilweise durch einen Gehäusekörper ausgebildet ist, insbesondere wobei der Gehäusekörper eine Gehäuseöffnung aufweist, die durch ein Deckelelement verschlossen ist und derart ausgestaltet ist, dass die Leiterplatte durch die Gehäuseöffnung hindurch in der Kavität montierbar ist. Das Deckelelement kann insbesondere plattenartig ausgestaltet sein, so dass eine Herstellung und Montage vereinfacht sein können. Vorzugsweise ist die Leiterplatte durch die Gehäuseöffnung hindurch in der Kavität montierbar, wenn das Deckelelement vom Gehäuse entfernt ist. Der Gehäusekörper kann somit einen wesentlichen Teil der Schutzwirkung für die Leiterplatte gegenüber Umweltbedingungen gewährleisten. Vorzugsweise kann der Gehäusekörper ein einzelnes Bauteil bilden, welches zumindest bereichsweise durch das Deckelelement verschlossen wird. Die Gehäuseöffnung kann daher eine Montageöffnung für die Leiterplatte bereitstellen. Vorzugsweise kann die Gehäuseöffnung somit größer dimensioniert sein als die Leiterplatte und/oder Maße aufweisen, welche Maßen der Leiterplatte entsprechen. Insbesondere kann vorgesehen sein, dass die Gehäuseöffnung derart ausgestaltet ist, dass eine Fläche der Leiterplatte, welche Schaltungselemente aufweist, parallel zu einem Gehäuseboden des Gehäusekörpers während des Einbringens der Leiterplatte in die Kavität orientierbar ist. Dadurch ist eine einfache Montage der Leiterplatte möglich. Insbesondere ist es dabei auch möglich, dass die Leiterplatte im Wesentlichen unabhängig von Verbindungselementen zum Verbinden der Leiterplatte mit den Anschlussbereichen montiert wird, sodass bspw. entweder zuerst die Verbindungselemente und anschließend die Leiterplatte oder zunächst die Leiterplatte und anschließend die Verbindungselemente in die Kavität eingebracht werden können und/oder miteinander verbunden werden können.

Vorzugsweise kann bei einer erfindungsgemäßen Elektronikeinheit das Deckelelement stoffschlüssig mit dem Gehäusekörper verbunden sein. Insbesondere kann dabei das Deckelelement mit dem Gehäusekörper laserverschweißt sein. Durch die stoffschlüssige Verbindung des Deckelelementes mit dem Gehäusekörper kann eine sichere Verbindung zwischen Deckelelement und Gehäusekörper erzielt werden. So kann die Elektronikeinheit bspw. im Einbauzustand im Fahrzeug widrigen Umweltbedingungen ausgesetzt sein, wie Staub, Steinschlag und insbesondere auch Frost oder Feuchtigkeit. Durch die stoffschlüssige Verbindung kann in einfacher Art und Weise eine sichere Verbindung gewährleistet werden, die derartige Umweltbedingungen aushalten kann. Insbesondere kann ferner das Deckelelement mit dem Gehäusekörper abgedichtet sein. Durch eine stoffschlüssige Verbindung kann somit gleichzeitig diese Abdichtung gewährleistet werden, sodass bspw. kein zusätzlicher Dichtungsring oder dergleichen notwendig sein kann. Eine Laserverschweißung ist ferner eine besonders sichere stoffschlüssige Verbindung, welche automatisierbar ist, sodass die Herstellkosten der Elektronikeinheit durch die Laserverschweißung gesenkt werden können. Zusätzlich oder alternativ kann das Deckelelement mit dem Gehäusekörper verklebt sein. Um eine redundante Absicherung gewährleisten zu können kann ferner vorgesehen sein, dass das Deckelelement form- und/oder kraftschlüssig mit dem Gehäusekörper verbunden ist. Dies kann bspw. durch entsprechende Rastelemente vorgesehen sein.

Die Kavität ist mit einer Vergussmasse zumindest teilweise ausgefüllt. Vorzugsweise kann dabei die Leiterplatte mit der Vergussmasse vergossen sein. Die Vergussmasse kann bei der Herstellung der Elektronikeinheit als flüssige Masse in die Kavität eingebracht werden und in der Kavität zumindest teilweise aushärten. Insbesondere kann die Vergussmasse ein Gießharz, vorzugsweise ein Polyurethan, aufweisen. Durch die Vergussmasse kann zum einen eine weitere Sicherung der elektronischen Elemente innerhalb der Kavität, insbesondere der Leiterplatte, gegenüber Feuchtigkeit und weiteren Umwelteinflüssen gewährleistet werden. Insbesondere kann die Vergussmasse gleichzeitig zu einer Dämpfungswirkung beitragen, sodass die Leiterplatte innerhalb der Kavität auch gegenüber Erschütterungen gedämpft ist. Während einer Fahrt des Fahrzeugs kann es zu starken Vibrationen und/oder Erschütterungen kommen, welche ggf. Elektronikelemente der Leiterplatte beschädigen könnten. Die Vergussmasse stellt dafür vorzugsweise einen sicheren Sitz der Leiterplatte sicher. Zusätzlich oder alternativ kann die Vergussmasse ein Polyesterharz, ein Epoxidharz, ein Silikonharz, ein Vinylesterharz oder eine Kombination der vorhergenannten aufweisen. Auch gegenüber weiteren Umwelteinflüssen, wie z.B. Feuchtigkeit, kann die Vergussmasse eine Schutzwirkung entfalten.

Es kann bei einer erfindungsgemäßen Elektronikeinheit ferner vorgesehen sein, dass sich von zumindest einem der Anschlussbereiche zumindest ein Verbindungselement zur Leiterplatte erstreckt und stoff-, form- und/oder kraftschlüssig mit der Leiterplatte verbunden ist. Dabei kann sich das Verbindungselement beispielsweise linear, kurvenförmig oder in einer anderen Geometrie vom Anschlussbereich zur Leiterplatte erstrecken. Vorzugsweise kann das Verbindungselement mittels einer Presspassung und/oder einer Kaltverschweißung mit der Leiterplatte verbunden sein. Bei dem Verbindungselement handelt es sich vorzugsweise um einen metallischen Verbinder, welcher bspw. mit einem Steckverbinder zum Anschluss des Sensors und/oder des Fahrzeugs verbunden werden kann. Insbesondere kann das Verbindungselement selbst einen Kontaktbereich bereitstellen, welcher eine elektrische Verbindung der Leiterplatte mit dem Fahrzeug oder dem Sensor zur Verfügung stellen kann. Dazu kann beispielsweise der Kontaktbereich des Verbindungselementes im Anschlussbereich angeordnet sein, so dass eine elektrische Verbindung des Fahrzeugs oder des Sensors am Kontaktbereich realisierbar ist. Insbesondere kann somit ein Ende des Verbindungselementes den Kontaktbereich bilden. Das Kaltverschweißen kann vorzugsweise unter hohem Druck erfolgen und durch eine plastische Deformation des Verbindungselementes und/oder eines Bereiches der Leiterplatte bei Anpressen der entsprechenden Kontaktflächen zueinander wirken. Dadurch ist zum einen eine sichere Verbindung von Verbindungselement und Anschlussbereich während des Betriebs der Elektronikeinheit sichergestellt und zum anderen ist auch eine elektrische Verbindung zwischen Verbindungselement und Leiterplatte sichergestellt. Dadurch kann die Funktionsfähigkeit in Bezug auf Zuverlässigkeit und Lebensdauer der Elektronikeinheit verbessert sein. Vorzugsweise kann sich jeweils zumindest ein Verbindungselement vom ersten und zweiten Anschlussbereich zur Leiterplatte erstrecken und stoff-, form- und/oder kraftschlüssig mit der Leiterplatte verbunden sein. Dadurch kann eine zuverlässige Anbindung der Leiterplatte sowohl an das Fahrzeug, als auch an den Sensor realisiert sein.

Im Rahmen der Erfindung ist es ferner denkbar, dass das Gehäuse, insbesondere der Gehäusekörper, zumindest einen ersten Verbindungsabschnitt und/oder einen zweiten Verbindungsabschnitt zur Aufnahme eines Steckverbinders aufweist. Durch den ersten Verbindungsabschnitt kann der erste Anschlussbereich zumindest teilweise gebildet sein und/oder durch den zweiten Verbindungsabschnitt kann der zweite Anschlussbereich zumindest teilweise gebildet sein. Vorzugsweise kann der erste und/oder der zweite Anschlussbereich ferner jeweils einen Steckverbinder umfassen oder durch jeweils einen Steckverbinder gebildet sein. Durch den Steckverbinder kann ein form- und/oder kraftschlüssiger Anschluss für einen Stecker ausgebildet sein. Durch den Verbindungsabschnitt ist eine Montage des Steckverbinders deutlich vereinfacht. Insbesondere können somit unterschiedliche Steckverbinder auf den Verbindungsabschnitt aufgesteckt werden, wenn unterschiedliche Normanschlüsse benötigt werden. Dadurch kann bspw. die Elektronikeinheit unabhängig vom Steckverbinder gefertigt werden, bevor dieser auf den Verbindungsabschnitt aufgebracht wird. Dadurch kann eine einheitliche Fertigung der Elektronikeinheit begünstigt sein und gleichzeitig eine Montage der Elektronikeinheit für unterschiedliche Normstecker gewährleistet sein. Insbesondere kann der Verbindungsabschnitt einstückig mit dem Gehäusekörper vorgesehen sein. Dadurch kann die Bauteilzahl der Elektronikeinheit weiter reduziert sein und die Herstellkosten können geringer sein, wenn der erste Verbindungsabschnitt nicht zusätzlich am Gehäusekörper manuell befestigt wird. Auch eine Abdichtung der Kavität kann dadurch begünstigt sein. Vorzugsweise kann ferner ein zweiter Verbindungsabschnitt zur Aufnahme eines weiteren Steckverbinders vorgesehen sein. Insbesondere kann der weitere Steckverbinder gemäß dem ersten Steckverbinder oder unterschiedlich zum ersten Steckverbinder ausgestaltet sein. Insbesondere ist die Leiterplatte somit zwischen dem ersten und dem zweiten Verbindungsabschnitt angeordnet. Weiterhin ist es denkbar, dass der Steckverbinder am ersten Verbindungsabschnitt montiert ist. Dabei kann vorzugsweise sich ein Teil des Steckverbinders in den ersten Verbindungsabschnitt hinein erstrecken, während ein weiteres Teil des Steckverbinders den ersten Verbindungsabschnitt umgibt. Dadurch kann eine sichere Verbindung gewährleistet werden und gleichzeitig eine Abdichtung vereinfacht sein. Insbesondere kann das Verbindungselement somit an den Steckverbinder angeschlossen sein, welcher wiederum eine Verbindung nach außen gewährleisten kann.

Es ist ferner denkbar, dass bei einer erfindungsgemäßen Elektronikeinheit das Verbindungselement einen U-förmigen Biegeabschnitt aufweist. Vorzugsweise kann dabei ein erster Schenkel des Biegeabschnitts an der Leiterplatte befestigt sein und/oder ein zweiter Schenkel des Biegeabschnitts an dem Verbindungsabschnitt befestigt sein. Dadurch ist es bspw. denkbar, dass zunächst das Verbindungselement in dem Gehäusekörper montiert wird, bevor die Leiterplatte auf das Verbindungselement aufgesteckt wird. Insbesondere kann somit der U-förmige Biegeabschnitt in Richtung eines Gehäusebodens des Gehäusekörpers geschlossen sein, insbesondere wobei der U-förmige Biegeabschnitt in Richtung der Gehäuseöffnung offen ist. Vorzugsweise ist die Leiterplatte derart in der Kavität angeordnet, dass die Leiterplatte zum Gehäuseboden beabstandet ist. Dadurch kann der Biegeabschnitt sich innerhalb dieses Abstandes erstrecken, sodass für den Verbinder kein zusätzlicher Bauraum benötigt wird, sondern ohnehin vorhandener Bauraum genutzt wird. Auch eine Montage der Leiterplatte kann dadurch vereinfacht sein.

Die Leiterplatte ist auf zumindest einer Positionierungshilfe angeordnet, sodass die Leiterplatte zu einem Gehäuseboden beabstandet ist. Die Positionierungshilfe kann vorzugsweise einen Dom aufweisen, welcher einen Positionierungsabsatz aufweist. Auf dem Positionierungsabsatz kann die Leiterplatte ablegbar sein, sodass eine Distanz zum Gehäuseboden gegeben ist. Dadurch kann die Leiterplatte bspw. von zwei Seiten mit Schaltelementen versehen sein, ohne dass eines der Schaltelemente direkt mit dem Gehäuseboden in Kontakt gerät. Vorzugsweise kann die Positionierungshilfe einstückig mit dem Gehäuse, insbesondere mit dem Gehäusekörper, vorgesehen sein. Dadurch kann die Bauteilanzahl weiter reduziert sein und damit die Herstellkosten weiter gesenkt werden. Insbesondere kann somit der Gehäusekörper werkzeugfallend verwendet werden und z.B. nach Anschluss der Verbindungselemente kann die Leiterplatte montiert werden.

Es ist ferner denkbar, dass bei einer erfindungsgemäßen Elektronikeinheit mehrere Positionierungshilfen derart angeordnet sind, dass bei einer Montage der Leiterplatte, die Leiterplatte in maximal zwei Orientierungen, bevorzugt in genau einer Orientierung, positionierbar ist. So können die Positionierungshilfen bspw. unregelmäßig in der Kavität angeordnet sein und auf Positionierungsschnittstellen der Leiterplatte abgestimmt sein. Vorzugsweise weist das Gehäuse drei Dome auf, welche sich im Montagezustand in Bohrungen der Leiterplatte erstrecken. Dadurch kann es bei der Montage vermieden werden, dass die Leiterplatte in falscher Orientierung eingebaut wird. Die Positionierungshilfen können jedoch auch regelmäßig, bspw. in einem Viereck, angeordnet sein, sodass zwei Orientierungen zugelassen sind. So ist es bspw. denkbar, dass die Leiterplatte eine Ober- und eine Unterseite aufweist, wobei die Oberseite, z.B. aufgrund von Elektronikbauteilen, von der Unterseite leicht zu unterscheiden ist. Sind nun zwei Orientierungen durch die Positionierungshilfe möglich, wobei in der ersten Orientierung die Leiterplatte mit der Oberseite aufwärts montiert ist und in der zweiten Orientierung mit der Oberseite abwärts montiert ist, kann dies bei der Montage einfach festgestellt werden, sodass es unwahrscheinlich ist, dass ein Monteur und/oder eine Qualitätskontrolle eine derartige Fehlorientierung übersieht. Durch das Vermeiden von Fehlorientierungen kann z.B. vermieden werden, dass Schalterelemente der Leiterplatte fehlerhaft dem ersten und/oder zweiten Anschlussbereich zugeordnet werden und damit eine Funktion der Elektronikeinheit nicht gewährleistet ist. Zusätzlich oder alternativ kann vorgesehen sein, dass die Positionierung derart ausgestaltet ist, dass bei einer Montage der Leiterplatte die Leiterplatte in maximal zwei Orientierungen, bevorzugt in genau einer Orientierung, positionierbar ist. Wenn jede Positionierungshilfe bspw. einen Dom aufweist und die Dome unterschiedliche Durchmesser aufweisen, kann somit eine Orientierung der Leiterplatte vorgegeben sein. Auch durch eine derartige Ausbildung ist eine fehlerhafte Montage in einfacher Art und Weise reduzierbar oder vermeidbar.

Vorzugsweise kann bei einer erfindungsgemäßen Elektronikeinheit das Gehäuse einen Kunststoff aufweisen. Insbesondere kann das Gehäuse aus Kunststoff bestehen. Kunststoff bietet eine einfache Möglichkeit, einen Nichtleiter zur Verfügung zu stellen, welcher die Funktionsweise der Leiterplatte nicht beeinflusst und gleichzeitig einen Schutz gegenüber Umweltbedingungen für die Leiterplatte bereitstellen kann. Somit kann das Gehäuse vorzugsweise eine elektrische Isolierung der Leiterplatte bereitstellen. Zusätzlich bietet Kunststoff eine günstige Herstellungsmethode bspw. durch Kunststoffspritzguss. Insbesondere kann das Deckelelement und/oder der Gehäusekörper das Kunststoff aufweisen. Vorzugsweise ist dabei das Deckelelement und/oder der Kunststoffkörper laserlichtdurchlässig ausgebildet, sodass eine Laserverschweißung des Gehäusekörpers mit dem Deckelelement möglich ist. Der Kunststoff kann z.B. ein Acrylnitril-Butadien-Styrol (ABS), ein Polyamid (PA), ein Polyactid (PLA), ein Polyethylenterephthalat (PET), ein Polyethylen (PE), ein Polypropylen (PP) und/oder ein Polybuthylentelerephthalat (PBT) aufweisen.

Im Rahmen der Erfindung ist ferner denkbar, dass die Leiterplatte einen Mikrocontroller zur Auswertung eines Messsignals des Sensors umfasst. Dadurch kann die Leiterplatte dazu ausgebildet sein, Daten des Messsignals in verarbeitbare Messdaten umzuwandeln. Daher kann es beispielsweise nicht notwendig sein, das Fahrzeugsteuergerät auf einen speziellen Messalgorithmus einzustellen. Insbesondere kann durch die Elektronikeinheit mit angeschlossenem Sensor ein eigenständiges Messsystem bildbar sein, welches dem Fahrzeug lediglich Ergebnisse der Messung zur Verfügung stellt und gegebenenfalls Energie vom Fahrzeug bezieht.

Es ist bei einer erfindungsgemäßen Elektronikeinheit ferner denkbar, dass die Leiterplatte zumindest einen ersten und zweiten Schaltungsbereich aufweist, wobei durch den ersten Schaltungsbereich eine Kommunikation mit dem Fahrzeug verarbeitbar ist und durch den zweiten Schaltungsbereich Signale des Sensors verarbeitbar sind. Vorzugsweise weist dabei der erste Schaltungsbereich einen geringeren Abstand zum ersten Anschlussbereich auf, als der zweite Schaltungsbereich. Somit können der erste und der zweite Schaltungsbereich insbesondere reihenartig angeordnet sein und jeweils benachbart auf der Leiterplatte vorgesehen sein. Dadurch kann eine erste Seite der Leiterplatte für den ersten Schaltungsbereich vorgesehen sein und eine zweite der Leiterplatte für den zweiten Schaltungsbereich. Daher kann ein größtmöglicher Abstand des ersten und zweiten Schaltungsbereiches voneinander auf der gleichen Leiterplatte gewährleistet werden. Dabei kann der erste Schaltungsbereich somit dem Fahrzeug zugeordnet sein und der zweite Schaltungsbereich dem Sensor. Dies kann eine Verbesserung der Messgenauigkeit des Sensors mit der Elektronikeinheit bewirken, wenn beispielsweise eine Masseleitung des Fahrzeuganschlusses vom zweiten Schaltungsbereich für den Sensor möglichst weit entfernt ist.

Vorzugsweise kann bei einer erfindungsgemäßen Elektronikeinheit das Gehäuse zumindest eine Befestigungsschnittstelle zur Befestigung des Gehäuses am Fahrzeug aufweisen. Insbesondere können mehrere Befestigungsschnittstellen für unterschiedliche Befestigungskonzepte vorgesehen sein. Insbesondere können die Befestigungsschnittstellen einstückig mit dem Gehäusekörper ausgebildet sein. Durch die Befestigungsschnittstelle kann eine einfache Art und Weise gegeben sein, die Elektronikeinheit am Fahrzeug zu befestigen. Sind mehrere Befestigungsschnittstellen für unterschiedliche Befestigungskonzepte an der Elektronikeinheit vorgesehen, ist es beispielsweise möglich die Elektronikeinheit kostengünstig für mehrere unterschiedliche Fahrzeugmodelle zu fertigen und gleichzeitig individuelle Befestigungskonzepte vorzusehen. Somit kann für jedes Befestigungskonzept zumindest eine Befestigungsschnittstelle vorgesehen sein. Insbesondere kann die Elektronikeinheit durch unterschiedliche Befestigungskonzepte auch an unterschiedlichen Stellen des Fahrzeuges montierbar sein. Eine Befestigungsschnittstelle kann beispielsweise eine Bohrung für eine Verschraubung umfassen, ein Rastmittel oder dergleichen. Unterschiedliche Befestigungskonzepte können ferner beispielsweise Laschen mit unterschiedlichen Lochgrößen, zumindest eine Bohrung und zumindest ein Rastmittel oder dergleichen umfassen.

Im Rahmen der Erfindung ist ferner denkbar, dass der Gehäusekörper eine Länge L von weniger als 150 mm, bevorzugt von weniger als 120 mm, besonders bevorzugt weniger als 105 mm, eine Breite B von weniger als 60 mm, bevorzugt weniger als 50 mm, und/oder eine Höhe H von weniger als 25 mm, vorzugsweise weniger als 20 mm, besonders bevorzugt weniger als 15 mm, aufweist. Insbesondere kann die gesamte Elektronikeinheit die vorgenannte Länge, Breite und/oder Höhe aufweisen. Besonders bevorzugt kann eine maximale Gehäusehöhe des Gehäuses geringer ausgebildet sein, als eine Höhe des Steckverbinders. Dadurch kann die Gesamthöhe der Elektronikeinheit lediglich durch den Steckverbinder bestimmt sein. Vorzugsweise kann ein Verhältnis der Länge des Gehäusekörpers zur Höhe des Gehäusekörpers (L zu H) ungefähr 8 betragen und/oder ein Verhältnis der Länge des Gehäusekörpers zur Breite des Gehäusekörpers (L zu B) ≥ 2, vorzugsweise ≥ 2,5, besonders bevorzugt ungefähr 3 sein. Der Begriff "ungefähr" kann dabei + oder - 10% umfassen. Die Breite B kann sich vorzugsweise auf ein Maß beziehen, welches die Breite der Kavität und die Wandstärken des Gehäusekörpers einschließt. Gemäß einem weiteren Aspekt der Erfindung ist ein Fahrzeug mit einer erfindungsgemäßen Elektronikeinheit beansprucht. Dabei ist die Elektronikeinheit mit einer Fahrzeugelektronik und einem Sensor verbunden. Vorzugsweise kann die Elektronikeinheit in einem Stoßfänger oder einer Seitentür des Fahrzeugs angeordnet sein. Insbesondere kann der Stoßfänger im Heckbereich des Fahrzeugs angeordnet sein, sodass die Elektronikeinheit bzw. der Sensor beispielsweise zur Betätigung einer Öffnung des Kofferraums des Fahrzeugs vorgesehen sein kann. Die Seitentür kann vorzugsweise eine Schiebetür sein. Damit bringt ein erfindungsgemäßes Fahrzeug die gleichen Vorteile mit sich, wie sie ausführlich mit Bezug auf eine erfindungsgemäße Elektronikeinheit beschrieben worden sind. Insbesondere kann die Elektronikeinheit lediglich wenig Bauraum im Fahrzeug beanspruchen und gleichzeitig eine hohe Zuverlässigkeit und/oder Genauigkeit des Sensors gewährleisten. Durch den geringen Bauraumbedarf der Elektronikeinheit können weitere Bauteile im Fahrzeug im Stoßfänger und/oder der Seitentür angeordnet sein, wie beispielsweise weitere Sensoren, und die Konstruktionsfreiheit und/oder Designfreiheit in Bezug auf den Stoßfänger und/oder die Seitentür kann verbessert sein. Durch die verbesserte Messgenauigkeit können beispielsweise Fehldetektionen des Sensors vermieden werden oder reduziert werden.

Gemäß einem weiteren Aspekt der Erfindung ist ein Herstellverfahren zum Herstellen einer Elektronikeinheit, vorzugsweise einer erfindungsgemäßen Elektronikeinheit, für einen Sensor für ein Fahrzeug beansprucht. Dabei umfasst das Herstellverfahren folgende Schritte:
- Zumindest teilweises Formen eines Gehäuses mit einer Kavität und Bereitstellen eines ersten Anschlussbereiches zum Verbinden der Elektronikeinheit mit dem Fahrzeug auf einer ersten Seite des Gehäuses und eines zweiten Anschlussbereiches zum Verbinden der Elektronikeinheit mit dem Sensor auf einer zweiten Seite des Gehäuses,
- Anordnen der Leiterplatte zumindest teilweise zwischen dem ersten und dem zweiten Anschlussbereich in der Kavität.

Somit bringt ein erfindungsgemäßes Herstellungsverfahren die gleichen Vorteile mit sich, wie sie ausführlich bereits in Bezug auf eine erfindungsgemäße Elektronikeinheit beschrieben worden sind. Die Anordnung des ersten und zweiten Anschlussbereiches auf der ersten bzw. zweiten Seite des Gehäuses kann beispielsweise dadurch vorgesehen werden, dass ein Kontaktbereich des ersten und zweiten Anschlussmittels mittels eines Kunststoffspritzgussverfahrens durch einen Teil des Gehäusekörpers umgeben wird. Das Formen des Gehäusekörpers kann von vorzugsweise in einem Kunststoffspritzguss erfolgen. Insbesondere kann das Formen in einem Zweikomponentenkunststoffspritzguss erfolgen, sodass mehrere Materialien für den Gehäusekörper kombiniert werden können. Eine Entformungsrichtung des Gehäusekörpers kann dabei vorzugsweise einer Montagerichtung der Leiterplatte entsprechen. So kann vorzugsweise oberhalb eines Gehäusebodens eine Gehäuseöffnung vorgesehen sein, durch welche die Leiterplatte montiert werden kann. Somit ergibt sich ein einfaches Herstellverfahren, welches kostengünstig ist. Gleichzeitig kann durch die Anordnung der Leiterplatte eine Verbesserung des Messsystems erreicht werden, wenn im angeschlossenen Zustand beispielsweise eine Masseleitung des Fahrzeugs keinen oder nur einen reduzierten Einfluss auf die Messelektronik auf der Leiterplatte hat. Gleichzeitig kann jedoch der Fahrzeuganschluss dennoch Energie für das Messsystem zur Verfügung stellen.

Vorzugsweise kann das Herstellverfahren folgenden Schritt umfassen:
- Zumindest teilweises Ausfüllen der Kavität mit einer Vergussmasse, insbesondere wobei die Leiterplatte mit der Vergussmasse vergossen wird.

Dadurch kann eine Vibrationsfestigkeit der Leiterplatte gegeben sein. Gleichzeitig kann eine elektrische Isolation der Leiterplatte gegenüber anderen Bauteilen gewährleistbar sein. Die Vergussmasse kann, wie bereits im Rahmen der Beschreibung zu einer erfindungsgemäßen Elektronikeinheit ausgeführt, ein Gießharz umfassen. Dadurch ist eine einfache Herstellung möglich, da beispielsweise die Vergussmasse lediglich nach Einsetzen der Leiterplatte in die Kavität in die Kavität eingegossen werden kann. In der Kavität kann die Vergussmasse schließlich aushärten, vorzugsweise bevor die Kavität mit einem Gehäusedeckel verschlossen wird.

Im Rahmen der Erfindung kann ferner vorgesehen sein, dass das Bereitstellen des ersten und zweiten Anschlussbereiches zumindest teilweise gleichzeitig mit dem zumindest teilweisen Formen des Gehäuses erfolgt, wobei ein Gehäusekörper des Gehäuses zumindest teilweise in den Anschlussbereichen ausgeformt wird, sodass die Anschlussbereiche zumindest teilweise durch den Gehäusekörper gebildet werden. Weiterhin kann beispielsweise ein Kontaktbereich des ersten und des zweiten Anschlussbereiches direkt durch den Gehäusekörper umspritzt werden. Zusätzlich oder alternativ ist es denkbar, dass Verbindungselemente und/oder Kontaktbereiche in den Anschlussbereichen, welche vorzugsweise einen metallischen Kontakt aufweisen, zunächst in einem Formverfahren, wie beispielsweise einem Sintern oder einem Gussverfahren, wie beispielsweise injection-molding, erzeugt werden und anschließend ein Kunststoff des Gehäusekörpers um die Verbindungselemente und/oder Kontaktbereiche herum gespritzt wird. Dadurch kann eine einstückige Verbindung gewährleistet werden, sodass die Verbindungselemente und/oder Kontaktbereiche sicher mit dem Gehäuse verbunden werden. Dadurch kann auch eine Montage der Leiterplatte, sofern diese anschließend stattfindet, vereinfacht werden, da eine Gefahr reduziert sein kann, dass beim Einsetzen der Leiterplatte Bauteile verrutschen.

Im Rahmen der Erfindung ist ferner denkbar, dass das Anordnen der Leiterplatte in der Kavität durch eine Gehäuseöffnung des Gehäuses hindurch erfolgt, wobei die Gehäuseöffnung nach dem Anordnen der Leiterplatte in der Kavität mit einem Deckelelement verschlossen wird. Insbesondere kann dabei vorgesehen sein, dass die Leiterplatte in die Kavität hineingelegt wird. Durch die Gehäuseöffnung und das Deckelelement kann ein großer Zugang zur Kavität ermöglicht sein, welcher anschließend insbesondere mediendicht verschlossen wird und somit dennoch eine sichere Aufbewahrung der Leiterplatte in der Kavität gewährleitstet sein kann.

Bei einem erfindungsgemäßen Herstellverfahren kann ferner vorgesehen sein, dass das Anordnen der Leiterplatte in der Kavität ein Einbringen der Leiterplatte in die Kavität umfasst, wobei die Leiterplatte während des Einbringens in einer Richtung senkrecht zu einem Gehäuseboden des Gehäusekörpers bewegt wird. Somit kann die Gehäuseöffnung vorzugsweise dem Gehäuseboden gegenüberliegen. Insbesondere kann beim Einbringen der Leiterplatte in die Kavität die Leiterplatte mit einer bedruckten Seite zum Gehäuseboden parallel orientiert sein, sodass ein Einsetzen und gleichzeitiges Positionieren der Leiterplatte erleichtert sein kann. Dadurch kann das Herstellverfahren insgesamt vereinfacht sein und somit kann die benötigte Zeit zum Montieren der Leiterplatte in der Kavität reduziert werden.

Im Rahmen der Erfindung ist ferner denkbar, dass das Deckelelement stoffschlüssig mit dem Gehäusekörper verbunden, insbesondere laserverschweißt, wird. Dadurch kann in einfacher Art und Weise eine Abdichtung gegenüber Flüssigkeiten und/oder Schmutz gewährleitstet werden, wobei das Laserverschweißen vorzugsweise automatisiert sein kann. Dadurch kann eine reproduzierbare Präzision gegeben sein, welche gleichzeitig kostengünstig sein kann und eine hohe Zuverlässigkeit bereitstellen kann.

Die Verfahrensschritte können zumindest teilweise parallel oder zeitlich nacheinander ablaufen, wobei die Reihenfolge der Verfahrensschritte nicht auf die beschriebene Reihenfolge begrenzt ist, sodass einzelne Schritte in unterschiedlicher Reihenfolge durchführbar sind. Insbesondere können einzelne oder alle Schritte des Verfahrens wiederholt werden.

Weitere, die Erfindung verbessernde Maßnahmen ergeben sich aus der nachfolgenden Beschreibung zu einigen Ausführungsbeispielen der Erfindung, welche in den Figuren schematisch dargestellt sind. Sämtliche aus den Ansprüchen, der Beschreibung oder den Zeichnungen hervorgehende Merkmale und/oder Vorteile, einschließlich konstruktiver Einzelheiten, räumliche Anordnungen und Verfahrensschritte können sowohl für sich, als auch in den verschiedensten Kombinationen erfindungswesentlich sein. Dabei ist zu beachten, dass die Figuren nur beschreibenden Charakter haben und nicht dazu gedacht sind, die Erfindung in irgendeiner Form einzuschränken. Es zeigen:
- Fig. 1: eine erfindungsgemäße Elektronikeinheit in unverschlossenem Zustand in schematischer Darstellung in einem ersten Ausführungsbeispiel,
- Fig. 2: die erfindungsgemäße Elektronikeinheit des ersten Ausführungsbeispiels in verschlossenem Zustand in schematischer Ansicht,
- Fig. 3: die erfindungsgemäße Elektronikeinheit des ersten Ausführungsbeispiels in schematischer teilweise geschnittener Seitenansicht,
- Fig. 4: eine schematische Draufsicht einer erfindungsgemäßen Elektronikeinheit in einem weiteren Ausführungsbeispiel,
- Fig. 5: die erfindungsgemäße Elektronikeinheit mit angeschlossenem Sensor und angeschlossener Fahrzeugelektronik des Ausführungsbeispiels der Figur 4 in schematischer Ansicht,
- Fig. 6: ein erfindungsgemäßes Fahrzeug mit einer erfindungsgemäßen Elektronikeinheit in schematischer Ansicht in einem weiteren Ausführungsbeispiel,
- Fig. 7: ein erfindungsgemäßes Verfahren mit schematischer Darstellung von Verfahrensschritten in einem weiteren Ausführungsbeispiel.

In den nachfolgenden Figuren werden für die gleichen technischen Merkmale auch von unterschiedlichen Ausführungsbeispielen die identischen Bezugszeichen verwendet.

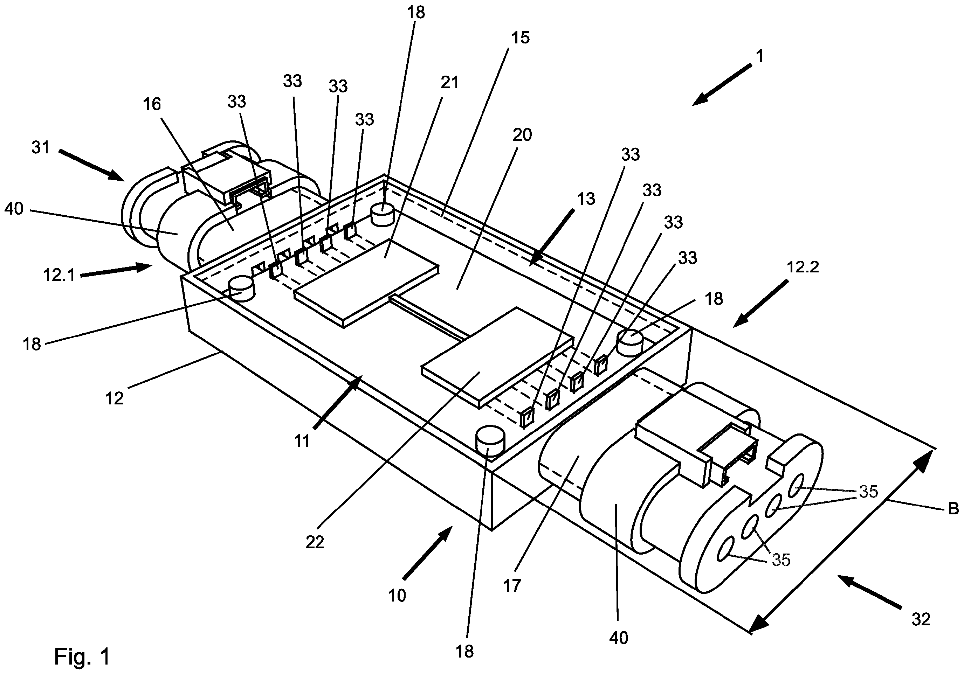

Figur 1 zeigt eine erfindungsgemäße Elektronikeinheit 1 für einen Sensor 2 für ein Fahrzeug 3 in einem ersten Ausführungsbeispiel in schematischer Ansicht. Dabei ist die Elektronikeinheit 1 ohne Deckelelement 14 dargestellt, sodass ein Gehäusekörper 12 eines Gehäuses 10 der Elektronikeinheit 1 offen dargestellt ist. Die Elektronikeinheit 1 weist auf einer ersten Seite 12.1 des Gehäuses 10 zur Verbindung mit dem Fahrzeug 3 einen ersten Anschlussbereich 31 und zur Verbindung mit dem Sensor 2 einen zweiten Anschlussbereich 32 auf einer zweiten Seite 12.2 des Gehäuses 10 auf. Dabei liegen sich die erste und zweite Seite 12.1, 12.2 des Gehäuses 10 in Bezug auf den Gehäusekörper 12 und/oder eine Leiterplatte 20 gegenüber. Somit können die erste und zweite Seite 12.1, 12.2 des Gehäuses 10 insbesondere Seiten des Gehäusekörpers 12 umfassen. Ferner weisen der erste und der zweite Anschlussbereich 31, 32 jeweils vorzugsweise zumindest einen metallischen Kontaktbereich 35 auf, an welchem eine elektrische Verbindung der Elektronikeinheit 1, insbesondere der Leiterplatte 20, mit dem Fahrzeug 3 bzw. dem Sensor 2 herstellbar ist. Insbesondere können die Kontaktbereiche 35 dabei Klemmen aufweisen, durch welche eine elektrische Verbindung zur Elektronikeinheit 1, insbesondere zur Leiterplatte 20, herstellbar ist. Die Kontaktbereiche 35 können ferner beispielsweise Teil eines Steckverbinders 40 sein. Die Leiterplatte 20 ist ferner in einer Kavität 11 des Gehäuses 10 angeordnet. Die Kavität 11 ist dabei zumindest bereichsweise durch den Gehäusekörper 12 ausgebildet. Innerhalb der Kavität 11 sind ferner Positionierungshilfen 18 vorgesehen, welche als Dome ausgebildet sind. Dadurch kann eine sichere Positionierung der Leiterplatte 20 in der Kavität 11 gewährleistet werden. Die Positionierungshilfen 18 sind insbesondere einstückig mit dem Gehäusekörper 12 vorgesehen. Ferner ragen die Positionierungshilfen 18 durch Öffnungen der Leiterplatte 20 hindurch, sodass sich auch eine formschlüssige Verbindung ergibt. Weiterhin sind die Positionierungshilfen 18 in der Kavität 11 symmetrisch zu einer Mitte der Kavität 11 angeordnet, sodass eine Positionierung der Leiterplatte 20 lediglich in maximal zwei Orientierungen möglich ist, nämlich mit Schaltelementen nach oben bzw. mit Schaltelementen nach unten orientiert. Dadurch kann ein Monteur, welcher die Leiterplatte ggf. falsch herum montiert oder montieren möchte, dies schnell feststellen. Die Leiterplatte 20 weist ferner einen ersten Schaltungsbereich 21 auf, durch welchen eine Kommunikation mit dem Fahrzeug 3 verarbeitbar ist und einen zweiten Schaltungsbereich 22, durch welchen Signale des Sensors 2 verarbeitbar sind. Insbesondere weist der zweite Schaltungsbereich 22 einen Mikrocontroller zur Auswertung eines Messsignals des Sensors 2 auf. Dadurch, dass der erste und zweite Schaltungsbereich 21, 22 reihenartig auf der Leiterplatte 20 angeordnet sind, weisen diese einen großen Abstand zueinander auf. Insbesondere weist der erste Schaltungsbereich 21 dabei einen geringeren Abstand zum ersten Anschlussbereich 31 für das Fahrzeug 3 auf als der zweite Schaltungsbereich 22. Dadurch wird eine Messauswertung des zweiten Schaltungsbereiches 22 nicht durch eine Verbindung des Fahrzeugs mit dem ersten Schaltungsbereich 21 gestört bzw. wird eine mögliche Störung wird reduziert. Zur Verbindung der Leiterplatte 20 mit dem Fahrzeug 3 bzw. dem Sensor 2 erstrecken sich vom ersten und zweiten Anschlussbereich 31, 32 jeweils Verbindungselemente 33 zur Leiterplatte 20. Vorzugsweise erstrecken sich jeweils vom ersten und zweiten Anschlussbereich 31,32 vier Verbindungelemente 33 zur Leiterplatte 20. Die Verbindungselemente 33 ragen durch Öffnungen der Leiterplatte 20 durch die Leiterplatte 20 hindurch, sodass eine elektrische Verbindung gewährleistet werden kann. Vorzugsweise ist für die Verbindung der Leiterplatte 20 mit den Verbindungselementen 33 eine Presspasssung vorgesehen. Insbesondere kann die Leiterplatte 20 ferner mit den Verbindungselementen 33 kaltverschweißt sein. Dadurch ergibt sich eine sichere Verbindung, welche zum einen mechanisch und zum anderen elektrisch zuverlässig sein kann. Zum Schutz gegenüber Umwelteinflüssen und/oder Vibrationen, ist ferner eine Vergussmasse 15 vorgesehen, welche die Kavität 11 zumindest teilweise ausfüllt. Insbesondere weist die Vergussmasse 15 ein Gießharz auf. Vorzugsweise kann die Vergussmasse 15 die Kavität 11 vollständig ausfüllen, insbesondere wenn die Kavität 11 verschlossen ist. Zur Montage der Elektronikeinheit 1 weist der Gehäusekörper 12 ferner eine Gehäuseöffnung 13 auf, welche derart ausgestaltet ist, dass die Leiterplatte 20 durch die Gehäuseöffnung 13 hindurch in der Kavität 11 montierbar ist. Insbesondere kann beim Einbringen der Leiterplatte 20 in die Kavität 11 die Leiterplatte 20 mit einer Seite, welche Schaltungselemente aufweist, parallel zu einem Gehäuseboden orientiert sein. Um eine Montage von insbesondere normgerechten Steckverbindern 40 gewährleisten zu können, weist das Gehäuse 10 ferner einen ersten Verbindungsabschnitt 16 und einen zweiten Verbindungsabschnitt 17 auf. Insbesondere sind der erste und zweite Verbindungsabschnitt 16, 17 einstückig mit dem Gehäusekörper 12 ausgeführt. Der erste Verbindungsabschnitt 16 ist dabei dem ersten Anschlussbereich 31 zugeordnet und der zweite Verbindungsabschnitt 17 ist dem zweiten Anschlussbereich 32 zugeordnet. Die Steckverbinder 40 erstrecken sich jeweils zumindest teilweise in die Verbindungsabschnitte 16, 17, um eine sichere Befestigung gewährleisten zu können. Dadurch, dass sich die Verbindungsabschnitte 16, 17 vom Gehäusekörper 12 erstrecken, ist eine einfache Montage der Steckverbinder 40 möglich. Insbesondere kann durch die Verbindungsabschnitte eine Montageschnittstelle für normgerechte Steckverbinder 40 gegeben sein. Vorzugsweise weist der Gehäusekörper 12 eine Länge L von weniger als 150 mm, bevorzugt von weniger als 120 mm, besonders bevorzugt von weniger als 105 mm, eine Breite B von weniger als 60 mm, bevorzugt von weniger als 50 mm und/oder eine Höhe H von weniger als 25, vorzugsweise weniger als 20 mm, besonders bevorzugt weniger als 15 mm, auf. Insbesondere kann die Elektronikeinheit 1 innerhalb dieser Maße liegen, wobei z.B. auch die Steckverbinder 40 inbegriffen sein können.

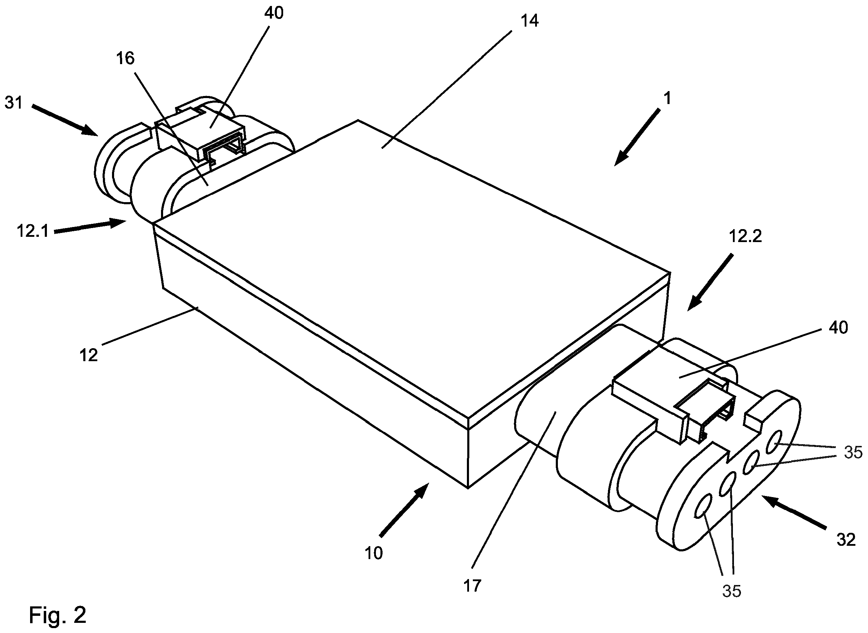

Figur 2 zeigt die erfindungsgemäße Elektronikeinheit 1 des ersten Ausführungsbeispiels der Figur 1 in einem verschlossenen Zustand. Dabei ist die Gehäuseöffnung 13 des Gehäusekörpers 12 mit einem Deckelelement 14 verschlossen, sodass die Leiterplatte 20 von außen nicht zugänglich ist. Insbesondere ist das Deckelelement 14 stoffschlüssig mit dem Gehäusekörper 12 verbunden, sodass die Kavität 11 mediendicht verschlossen sein kann. Dazu kann das Deckelelement 14 und/oder der Gehäusekörper 12 vorzugsweise einen Kunststoff aufweisen, welcher laserlichtdurchlässig ist. Insbesondere können das Deckelement 14 und der Gehäusekörper 12 laserverschweißt sein. Durch das Deckelelement 14 ist zunächst eine komfortable, einfache Montage der Leiterplatte 20 in der Kavität 11 möglich, wobei die Leiterplatte 20 sicher positioniert werden kann und auch ggf. notwendige Befestigungen von Bauteilen durchgeführt werden können. Auch das Einbringen der Vergussmasse 15 ist durch eine große Gehäuseöffnung 13 erleichtert. Gleichzeitig bietet das Deckelelement 14 eine Sicherheit gegenüber widrigen Umweltbedingungen der Elektronik der Elektronikeinheit 1 während des Betriebes der Elektronikeinheit 1.

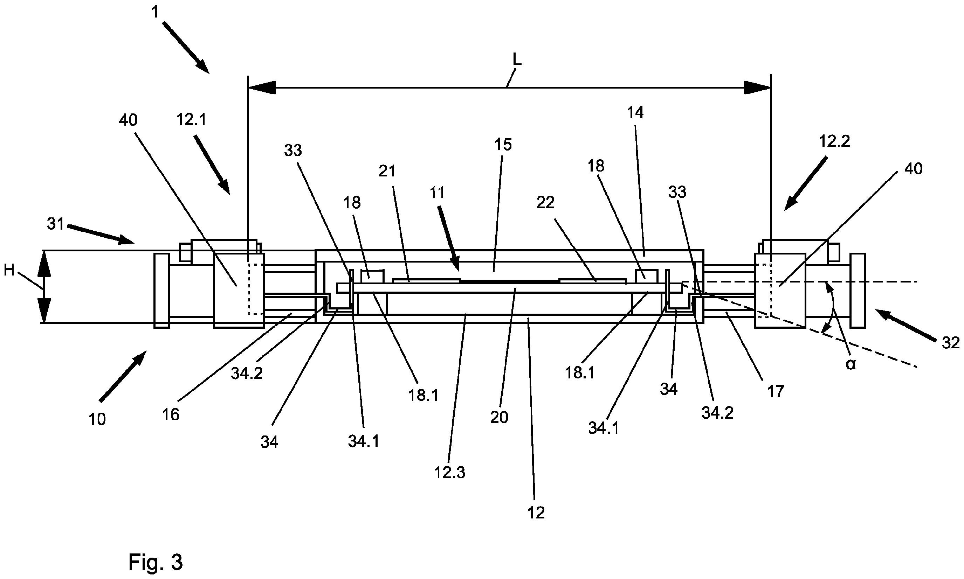

Figur 3 zeigt die erfindungsgemäße Elektronikeinheit 1 in schematischer, teilweise geschnittener Ansicht des ersten Ausführungsbeispiels. Dabei wird deutlich, dass die Verbindungselemente 33 einen U-förmigen Biegeabschnitt 34 aufweisen. Insbesondere ist ein erster Schenkel 34.1 des Biegeabschnitts 34 an der Leiterplatte 20 befestigt und ein zweiter Schenkel 34.2 des Biegeabschnitts 34 an dem Verbindungsabschnitt 16 bzw. 17. Der U-förmige Biegeabschnitt 34 ist dabei in Richtung eines Gehäusebodens 12.3 geschlossen und insbesondere in Richtung der Gehäuseöffnung 13 offen. Dadurch ist gewährleistet, dass der erste Schenkel 34.1 jeweils sich in Richtung der Gehäuseöffnung 13 erstreckt und die Leiterplatte 20 in einfacher Art und Weise mit dem jeweiligen Verbindungselement 33 verbindbar ist. Ferner weisen die Positionierungshilfen 18 jeweils einen Positionierungsabsatz 18.1 auf, auf welchem die Leiterplatte 20 aufliegt. Dadurch kann in einfacher Art und Weise gewährleistet sein, dass die Leiterplatte 20 zum Gehäuseboden 12.3 beabstandet ist. Dadurch werden Elektronikelemente der Leiterplatte 20 nicht durch den Gehäuseboden 12.3 kontaktiert und/oder Vibrationen werden nicht unmittelbar übertragen. Die Anschlussbereiche 31, 32 können, wie gezeigt, parallel zueinander in einer Ebene liegen oder einen Winkel α zueinander und/oder zur Leiterplatte 20 aufweisen.

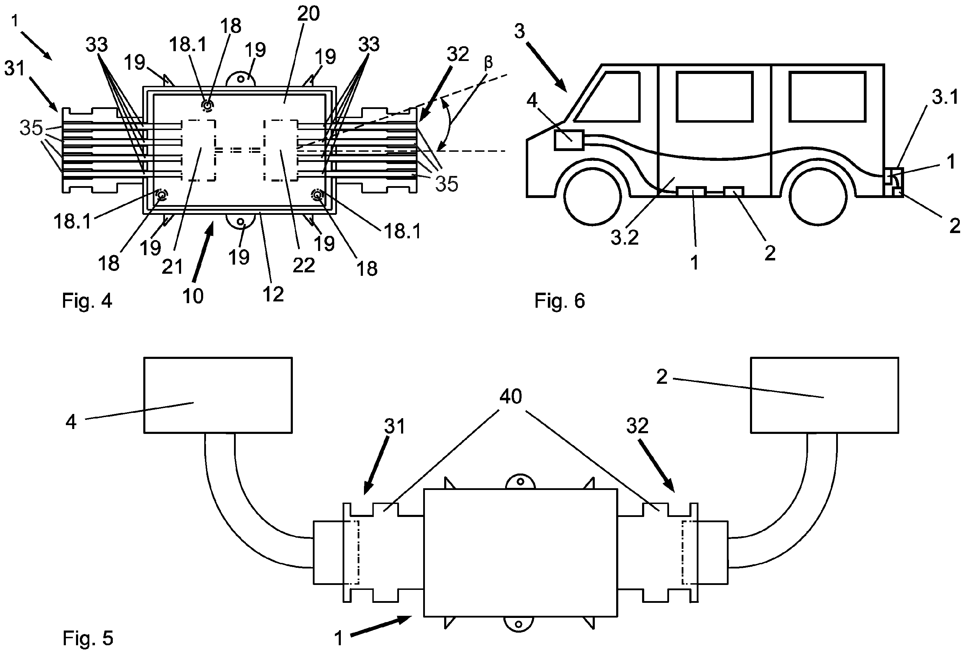

Figur 4 zeigt ferner eine erfindungsgemäße Elektronikeinheit 1 in einem weiteren Ausführungsbeispiel in schematischer Draufsicht in geöffnetem Zustand. Dabei weist die Elektronikeinheit 1 einen ersten Anschlussbereich 31 und einen zweites Anschlussbereich 32 auf. Der erste Anschlussbereich 31 ist dazu ausgebildet, eine Verbindung einer Leiterplatte 20 mit einem Fahrzeug 3 herzustellen und der zweite Anschlussbereich 32 ist dazu ausgebildet, eine Verbindung der Leiterplatte 20 mit einem Sensor 2 herzustellen. Die Leiterplatte 20 ist zwischen den Anschlussbereichen 31, 32 angeordnet, wobei sich die Anschlussbereiche 31, 32 in Bezug auf die Leiterplatte 20 gegenüberliegen. Insbesondere können die Anschlussbereiche 31, 32 beispielsweise einen Winkel β zueinander und/oder zur Leiterplatte 20 aufweisen. Dazu sind Verbindungselemente 33 vorgesehen, welche eine elektrische Verbindung der Leiterplatte 20 nach außen gewährleisten können. Insbesondere können die Verbindungselemente 33 metallisch ausgebildet sein. Zum Schutz gegenüber Umweltbedingungen, ist die Leiterplatte 20 ferner in einer Kavität 11 eines Gehäuses 10 angeordnet, wobei die Kavität 11 zumindest teilweise durch einen Gehäusekörper 12 gebildet ist. In der Kavität 11 sind ferner Positionierungshilfen 18 vorgesehen, wobei insbesondere drei Positionierungshilfen 18 derart angeordnet sind, dass die Leiterplatte 20 lediglich in genau einer Orientierung in der Kavität 11 korrekt anordbar ist. So ist zumindest eine der Positionierungshilfen 18 unregelmäßig angeordnet, sodass die Leiterplatte 20 bspw. in umgedrehter Orientierung nicht in der Kavität 11 montierbar ist. Insgesamt ist die Leiterplatte 20 zwischen den Anschlussbereichen 31, 32 angeordnet, sodass ein erster Schaltungsbereich 21, welcher dem ersten Anschlussbereich für das Fahrzeug zugeordnet ist und ein zweiter Schaltungsbereich 22, welcher dem zweiten Anschlussbereich 32 für den Sensor 2 zugeordnet ist reihenartig angeordnet sind. Dadurch ist eine Beeinflussung des zweiten Schaltungsbereichs 22 für den Sensor 2 durch das Fahrzeug 3 bzw. den ersten Schaltungsbereich 21 reduziert oder vermieden. Zudem weist das Gehäuse 10 Befestigungsschnittstellen 19 für unterschiedliche Befestigungskonzepte auf. So zeigt Figur 4 zum einen Befestigungsschnittstellen 19, welche als Rasthaken ausgebildet sind, und zum anderen Befestigungsschnittstellen 19, welche eine Befestigungslasche mit einer Bohrung aufweisen. Durch die unterschiedlichen Befestigungsschnittstellen 19 ist die Elektronikeinheit 1 für mehrere Fahrzeugtypen adaptierbar, ohne dass es beispielsweise notwendig ist, ein Gießwerkzeug zum Herstellen des Gehäuses 10 individuell anzupassen.

Figur 5 zeigt ferner die erfindungsgemäße Elektronikeinheit 1 des Ausführungsbeispiels der Figur 4 in schematischer Ansicht mit angeschlossenem Sensor 2 und Fahrzeug 3. Der erste Anschlussbereich 31 ist dabei mit einer Fahrzeugelektronik 4 des Fahrzeugs 3, insbesondere einem Fahrzeugsteuergerät, verbunden und der zweite Anschlussbereich 32 mit dem Sensor 2. Der Sensor 2 kann vorzugsweise ein Fußschalter für das Fahrzeug 3 sein.

Figur 6 zeigt ferner ein erfindungsgemäßes Fahrzeug in einem weiteren Ausführungsbeispiel. Dabei weist das Fahrzeug zwei Elektronikeinheiten 1 auf, wobei eine der Elektronikeinheiten 1 in einer Seitentür 3.2 angeordnet ist und eine weitere Elektronikeinheit 1 der Elektronikeinheiten in einem Stoßfänger des Fahrzeugs 3 angeordnet ist. Jede der Elektronikeinheiten 1 ist mit einem Sensor 2 verbunden, welcher vorzugsweise als Fußschalter ausgebildet sein kann. Dadurch kann bspw. mittels einer Gestensteuerung einer Fahrzeugfunktion, insbesondere eine Öffnung einer Tür oder eines Kofferraums ausgelöst werden. Zur Energieversorgung bzw. zur Weitergabe der Messergebnisse ist ferner jede der Elektronikeinheiten 1 mit einer Fahrzeugelektronik 4, welche vorzugsweise ein Fahrzeugsteuergerät sein kann, verbunden. Vorzugsweise ist jede der Elektronikeinheiten 1 gemäß einem der Ausführungsbeispiele der Figuren 1 bis 5 ausgebildet. Durch die Elektronikeinheiten 1 ist eine Anschlussmöglichkeit im Fahrzeug 3 vereinfacht und auch ein benötigter Bauraum der Elektronikeinheiten 1 ist verringert.

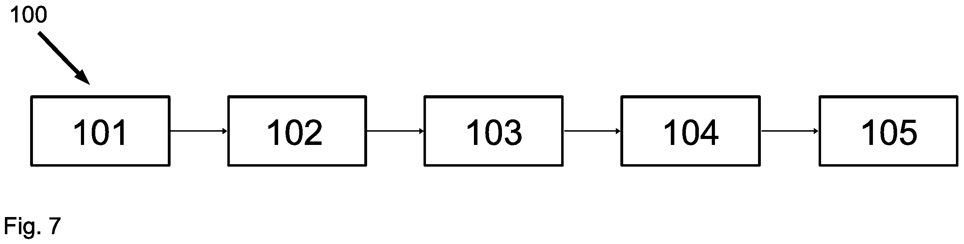

Figur 7 zeigt ferner ein erfindungsgemäßes Herstellverfahren 100 zum Herstellen einer Elektronikeinheit 1 für einen Sensor 2 für ein Fahrzeug 3 gemäß eines weiteren Ausführungsbeispiels in schematischer Darstellung von Verfahrensschritten. Dabei ist zum einen ein Bereitstellen 101 eines ersten Anschlussbereiches 31 und eines zweiten Anschlussbereiches 32 vorgesehen. Der erste Anschlussbereich 31 dient zum Verbinden der Elektronikeinheit 1 mit dem Fahrzeug 3 und der zweite Anschlussbereich 32 zum Verbinden der Elektronikeinheit 1 mit dem Sensor 2. Vorzugsweise zumindest teilweise gleichzeitig mit dem Bereitstellen 101 des ersten und zweiten Anschlussbereiches 31, 32 ist ein zumindest teilweises Formen 102 eines Gehäuses 10 mit einer Kavität 11 vorgesehen. Das Formen 102 des Gehäuses 10 umfasst dabei vorzugsweise, dass ein Gehäusekörper 12 geformt wird, welcher die Kavität 11 zumindest teilweise bildet. Dabei wird auf einer ersten Seite 12.1 des Gehäuses 10 ein erster Verbindungsabschnitt 16 und auf einer zweiten Seite 12.1 des Gehäuses 10 ein zweiter Verbindungsabschnitt 17 einstückig mit dem Gehäusekörper 12 ausgebildet. Insbesondere kann das Formen 102 in einem Kunststoffspritzgussverfahren durchgeführt werden, sodass der Gehäusekörper 12 anschließend einen Kunststoff aufweist und während des Formens 102 um Verbindungselemente 33 und/oder Kontaktbereiche 35 des ersten und/oder zweiten Anschlussbereiches 31, 32 herum gegossen wird. Insbesondere nach dem Formen 102 ist ein Anordnen 103 der Leiterplatte 20 zwischen dem ersten und zweiten Anschlussbereich 31, 32 in der Kavität 11 vorgesehen. Das Anordnen 103 der Leiterplatte 20 in der Kavität 11 findet dabei vorzugweise durch eine Gehäuseöffnung 13 des Gehäusekörpers 12 hindurch statt, wobei die Gehäuseöffnung 13 nach dem Anordnen 103 der Leiterlatte 20 in der Kavität 11 mit einem Deckelelement 14 verschlossen wird. Insbesondere wird die Leiterplatte 20 während des Einbringens in die Kavität 11 in einer Richtung senkrecht zu einem Gehäuseboden 12.3 des Gehäusekörpers 12 bewegt. Dadurch ist eine besonders einfache Montage möglich und gleichzeitig kann eine Verbindung mit weiteren Bauteilen in einfacher Art und Weise gewährleistet werden, wenn der Zugriff zur Montage nicht durch eine seitliche Gehäuseöffnung bspw. stattfindet. Ferner ist ein zumindest teilweises Ausfüllen 104 der Kavität 11 mit einer Vergussmasse 15 vorgesehen, sodass die Leiterplatte 20 mit der Vergussmasse 15 vergossen wird. Dadurch wird die Leiterplatte 20 durch die Vergussmasse weiter geschützt und ggf. vor Vibrationen während des Betriebs des Fahrzeugs 3 bewahrt. Weiterhin umfasst das Herstellverfahren 100 ein Verschließen 105 der Kavität 11 mit einem Deckelelement 14. Insbesondere wird dabei das Deckelelement 14 stoffschlüssig mit dem Gehäusekörper 12 verbunden, vorzugsweise laserverschweißt. Dadurch kann eine besonders sichere Verbindung insbesondere gelichzeigt mit einer Abdichtung gewährleistet werden. Es kann vorgesehen sein, dass die Verfahrensschritte des Herstellverfahrens 100 in der dargestellten oder in einer anderen Reihenfolge durchgeführt werden. Insbesondere können die Verfahrensschritte zumindest teilweise gleichzeitig ausgeführt werden.

Die voranstehende Erläuterung der Ausführungsform beschreibt die vorliegende Erfindung ausschließlich im Rahmen von Beispielen. Selbstverständlich können einzelne Merkmale der Ausführungsform, sofern technisch sinnvoll, frei miteinander kombiniert werden, ohne den Rahmen der vorliegenden Erfindung zu verlassen.

### B e z u a s z e i c h e n l i s t e

- 1: Elektronikeinheit
- 2: Sensor
- 3: Fahrzeug
- 3.1: Stoßfänger
- 3.2: Seitentür
- 4: Fahrzeugelektronik
- 10: Gehäuse
- 11: Kavität
- 12: Gehäusekörper
- 12.1: erste Seite
- 12.2: zweite Seite
- 12.3: Gehäuseboden
- 13: Gehäuseöffnung
- 14: Deckelelement
- 15: Vergussmasse
- 16: erster Verbindungsabschnitt
- 17: zweiter Verbindungsabschnitt
- 18: Positionierungshilfe
- 18.1: Positionierungsabsatz
- 19: Befestigungsschnittstelle
- 20: Leiterplatte
- 21: erster Schaltungsbereich
- 22: zweiter Schaltungsbereich
- 31: erster Anschlussbereich
- 32: zweiter Anschlussbereich
- 33: Verbindungselement
- 34: Biegeabschnitt
- 34.1: erste Schenkel
- 34.2: zweiter Schenkel
- 35: Kontaktbereich
- 40: Steckverbinder
- 100: Herstellverfahren
- 101: Verfahrensschritt
- 102: Verfahrensschritt
- 103: Verfahrensschritt
- 104: Verfahrensschritt
- 105: Verfahrensschritt
- B: Breite
- H: Höhe
- L: Länge

## Patentansprüche

1. Elektronikeinheit (1) für einen Sensor (2), insbesondere einen Fußschalter, für ein Fahrzeug (3), mit
einem ersten Anschlussbereich (31) zum Verbinden der Elektronikeinheit (1) mit dem Fahrzeug (3),
einem zweiten Anschlussbereich (32) zum Verbinden der Elektronikeinheit (1) mit dem Sensor (2),
einem Gehäuse (10) und einer Leiterplatte (20),
wobei die Leiterplatte (20) in einer Kavität (11) des Gehäuses (10) angeordnet ist, wobei
die Leiterplatte (20) zumindest teilweise zwischen dem ersten Anschlussbereich (31) und dem zweiten Anschlussbereich (32) angeordnet ist,
wobei die Kavität (11) mit einer Vergussmasse (15) zumindest teilweise ausgefüllt ist, wobei die Leiterplatte (20) auf zumindest einer Positionierungshilfe (18) angeordnet ist, so dass die Leiterplatte (20) zu einem Gehäuseboden (12.3) beabstandet ist.

2. Elektronikeinheit (1) nach Anspruch 1,
**dadurch gekennzeichnet,**
**dass** die Kavität (11) des Gehäuses (10) zumindest teilweise durch einen Gehäusekörper (12) ausgebildet ist, insbesondere wobei der Gehäusekörper (12) eine Gehäuseöffnung (13) aufweist, die durch ein Deckelement (14) verschlossen ist und derart ausgestaltet ist, dass die Leiterplatte (20) durch die Gehäuseöffnung (13) hindurch in der Kavität (11) montierbar ist, insbesondere wenn das Deckelement (14) vom Gehäuse (10) entfernt ist.

3. Elektronikeinheit (1) nach Anspruch 1 oder 2,
**dadurch gekennzeichnet,**
**dass** das Deckelelement (14) stoffschlüssig mit dem Gehäusekörper (12) verbunden ist.

4. Elektronikeinheit (1) nach einem der vorhergehenden Ansprüche,
**dadurch gekennzeichnet,**
**dass** sich von zumindest einem der Anschlussbereiche (31, 32) zumindest ein Verbindungselement (33) zur Leiterplatte (20) erstreckt und stoff-, form- und/oder kraftschlüssig mit der Leiterplatte (20) verbunden ist und/oder dass das Gehäuse (10) einen ersten Verbindungsabschnitt (16) und/oder einen zweiten Verbindungsabschnitt (17) zur Aufnahme eines Steckverbinders (40) aufweist.

5. Elektronikeinheit (1) nach Anspruch 4,
**dadurch gekennzeichnet,**
**dass** das Verbindungselement (33) einen U-förmigen Biegeabschnitt (34) aufweist, insbesondere wobei ein erster Schenkel (34.1) des Biegeabschnitts (34) an der Leiterplatte (20) befestigt ist und/oder ein zweiter Schenkel (34.2) des Biegeabschnitts (34) an dem Verbindungsabschnitt (16) befestigt ist.

6. Elektronikeinheit (1) nach einem der vorhergehenden Ansprüche,
**dadurch gekennzeichnet,**
**dass** mehrere Positionierungshilfen (18) derart angeordnet sind, dass bei einer Montage der Leiterplatte (20), die Leiterplatte (20) in maximal zwei Orientierungen, bevorzugt in genau einer Orientierung, positionierbar ist.

7. Elektronikeinheit (1) nach einem der vorhergehenden Ansprüche,
**dadurch gekennzeichnet,**
**dass** das Gehäuse (10) einen Kunststoff aufweist, und/oder dass die Leiterplatte (20) einen Mikrocontroller zur Auswertung eines Messsignals des Sensors (2) umfasst.

8. Elektronikeinheit (1) nach einem der vorhergehenden Ansprüche,
**dadurch gekennzeichnet,**
**dass** die Leiterplatte (20) zumindest einen ersten und einen zweiten Schaltungsbereich (21, 22) aufweist, wobei durch den ersten Schaltungsbereich (21) eine Kommunikation mit dem Fahrzeug (3) verarbeitbar ist, und durch den zweiten Schaltungsbereich (22) Signale des Sensors (2) verarbeitbar sind, insbesondere wobei der erste Schaltungsbereich (21) einen geringeren Abstand zum ersten Anschlussbereich (31) aufweist, als der zweite Schaltungsbereich (22).

9. Elektronikeinheit (1) nach einem der vorhergehenden Ansprüche,
**dadurch gekennzeichnet,**
**dass** das Gehäuse (10) zumindest eine Befestigungsschnittstelle (19) zur Befestigung des Gehäuses (10) am Fahrzeug (3) aufweist, insbesondere wobei mehrere Befestigungsschnittstellen (19) für unterschiedliche Befestigungskonzepte vorgesehen sind.

10. Elektronikeinheit (1) nach einem der vorhergehenden Ansprüche,
**dadurch gekennzeichnet,**
**dass** der Gehäusekörper (12) eine Länge (L) von weniger als 150 mm, bevorzugt von weniger als 120 mm, besonders bevorzugt von weniger als 105 mm, eine Breite (B) von weniger als 60 mm, bevorzugt weniger als 50 mm, und/oder eine Höhe (H) von weniger als 25 mm, vorzugsweise weniger als 20 mm, besonders bevorzugt weniger als 15 mm, aufweist.

11. Fahrzeug (3) mit einer Elektronikeinheit (1) nach einem der vorhergehenden Ansprüche, welche mit einer Fahrzeugelektronik (4) und einem Sensor (2) verbunden ist, insbesondere wobei die Elektronikeinheit (1) in einem Stoßfänger (3.1) oder einer Seitentür (3.2) des Fahrzeugs (3) angeordnet ist.

12. Herstellverfahren (100) zum Herstellen einer Elektronikeinheit (1), nach einem der Ansprüche 1 bis 10, für einen Sensor (2) für ein Fahrzeug (3), umfassend die folgenden Schritte:
- Zumindest teilweises Formen (102) eines Gehäuses (10) mit einer Kavität (11) und Bereitstellen (101) eines ersten Anschlussbereiches (31) zum Verbinden der Elektronikeinheit (1) mit dem Fahrzeug (3) auf einer ersten Seite (12.1) des Gehäuses (10) und eines zweiten Anschlussbereiches (32) zum Verbinden der Elektronikeinheit (1) mit dem Sensor (2) auf einer zweiten Seite (12.2) des Gehäuses (10),
- Anordnen (103) der Leiterplatte (20) zwischen dem ersten und dem zweiten Anschlussbereich (31, 32) in der Kavität (11).

13. Herstellverfahren (100) nach Anspruch 12,
**dadurch gekennzeichnet,**
**dass** das Herstellverfahren ferner folgenden Schritt umfasst:
- Zumindest teilweises Ausfüllen (104) der Kavität (11) mit einer Vergussmasse (15), insbesondere wobei die Leiterplatte (20) mit der Vergussmasse (15) vergossen wird.

14. Herstellverfahren (100) nach einem der Ansprüche 12 oder 13,
**dadurch gekennzeichnet,**
**dass** das Bereitstellen (101) des ersten und zweiten Anschlussbereiches (31, 32) zumindest teilweise gleichzeitig mit dem zumindest teilweisen Formen (102) des Gehäuses (10) erfolgt, wobei ein Gehäusekörper (12) des Gehäuses (10) zumindest teilweise in den Anschlussbereichen (31, 32) ausgeformt wird, so dass die Anschlussbereiche (31, 32) zumindest teilweise durch den Gehäusekörper (12) gebildet werden.

15. Herstellverfahren (100) nach einem der vorhergehenden Ansprüche,
**dadurch gekennzeichnet,**
**dass** das Anordnen (103) der Leiterplatte (20) in der Kavität (11) durch eine Gehäuseöffnung (13) des Gehäuses (10) hindurch erfolgt, wobei die Gehäuseöffnung (13) nach dem Anordnen (103) der Leiterplatte (20) in der Kavität (11) mit einem Deckelelement (14) verschlossen wird und/oder dass das Anordnen (103) der Leiterplatte (20) in der Kavität (11) ein Einbringen der Leiterplatte (20) in die Kavität (11) umfasst, wobei die Leiterplatte (20) während des Einbringens in einer Richtung senkrecht zu einem Gehäuseboden (12.3) des Gehäusekörpers (12) bewegt wird.

16. Herstellverfahren (100) nach einem der vorhergehenden Ansprüche,
**dadurch gekennzeichnet,**
**dass** das Deckelement (14) stoffschlüssig mit dem Gehäusekörper (12) verbunden, insbesondere laserverschweißt, wird.

## Claims

1. Electronic unit (1) for a sensor (2), in particular a foot switch, for a vehicle (3), with
a first connection region (31) for connecting the electronic unit (1) to the vehicle (3),
a second connection region (32) for connecting the electronic unit (1) to the sensor (2), a housing (10) and a printed circuit board (20),
wherein the printed circuit board (20) is arranged in a cavity (11) of the housing (10),
wherein the printed circuit board (20) is disposed at least partially between the first connection region (31) and the second connection region (32),
wherein the cavity (11) is at least partially filled with a potting compound (15),
wherein the printed circuit board (20) is arranged on at least one positioning aid (18) so that the printed circuit board (20) is spaced from a housing base (12.3).

2. Electronic unit (1) according to claim 1,
**characterized in that**
the cavity (11) of the housing (10) is formed at least partially by a housing body (12), in particular the housing body (12) having a housing opening (13) which is closed by a cover element (14) and is designed in such a way that the printed circuit board (20) can be mounted in the cavity (11) through the housing opening (13), in particular when the cover element (14) is removed from the housing (10).

3. Electronic unit (1) according to claim 1 or 2,
**characterized in that**
the cover element (14) is connected to the housing body (12) by a material bond.

4. Electronic unit (1) according to any one of the preceding claims,
**characterized in that**
at least one connecting element (33) extends from at least one of the connection regions (31, 32) to the printed circuit board (20) and is connected to the printed circuit board (20) in a materially, positively and/or non-positively locking manner, and/or **in that** the housing (10) has a first connecting section (16) and/or a second connecting section (17) for accommodating a plug connector (40).

5. Electronic unit (1) according to claim 4,
**characterized in that**
the connecting element (33) has a U-shaped bending section (34), in particular a first leg (34.1) of the bending section (34) being fastened to the printed circuit board (20) and/or a second leg (34.2) of the bending section (34) being fastened to the connecting section (16).

6. Electronic unit (1) according to any one of the preceding claims,
**characterized in that**
a plurality of positioning aids (18) are arranged in such a way that, during assembly of the printed circuit board (20), the printed circuit board (20) can be positioned in at most two orientations, preferably in exactly one orientation.

7. Electronic unit (1) according to any one of the preceding claims,
**characterized in that**
the housing (10) has a plastic, and/or **in that** the printed circuit board (20) comprises a microcontroller for evaluating a measurement signal from the sensor (2).

8. Electronic unit (1) according to any one of the preceding claims,
**characterized in that**
the printed circuit board (20) has at least a first and a second circuit region (21, 22), it being possible to process communication with the vehicle (3) by means of the first circuit region (21), and it being possible to process signals from the sensor (2) by means of the second circuit region (22), in particular the first circuit region (21) being at a smaller distance from the first connection region (31) than the second circuit region (22).

9. Electronic unit (1) according to any one of the preceding claims,
**characterized in that**
the housing (10) has at least one fastening interface (19) for fastening the housing (10) to the vehicle (3), in particular with a plurality of fastening interfaces (19) being provided for different fastening concepts.

10. Electronic unit (1) according to any one of the preceding claims,
**characterized in that**
the housing body (12) has a length (L) of less than 150 mm, preferably less than 120 mm, particularly preferably less than 105 mm, a width (B) of less than 60 mm, preferably less than 50 mm, and/or a height (H) of less than 25 mm, preferably less than 20 mm, particularly preferably less than 15 mm.

11. Vehicle (3) having an electronics unit (1) according to one of the preceding claims, which is connected to vehicle electronics (4) and a sensor (2), in particular wherein the electronics unit (1) is arranged in a bumper (3.1) or a side door (3.2) of the vehicle (3).

12. A manufacturing method (100) for manufacturing an electronic unit (1), according to any one of claims 1 to 10, for a sensor (2) for a vehicle (3), comprising the following steps:
- At least partially forming (102) a housing (10) with a cavity (11) and providing (101) a first connection region (31) for connecting the electronic unit (1) to the vehicle (3) on a first side (12.1) of the housing (10) and a second connection region (32) for connecting the electronic unit (1) to the sensor (2) on a second side (12.2) of the housing (10),
- Disposing (103) the printed circuit board (20) between the first and second connection regions (31, 32) in the cavity (11).

13. Manufacturing method (100) according to claim 12,
**characterized in that**
the manufacturing method further comprises the following step:
- At least partially filling (104) the cavity (11) with a potting compound (15), in particular wherein the printed circuit board (20) is poured with the potting compound (15).

14. Manufacturing method (100) according to any one of claims 12 or 13,
**characterized in that**
providing (101) of the first and second connection regions (31, 32) takes place at least partially simultaneously with the at least partial forming (102) of the housing (10), a housing body (12) of the housing (10) being formed at least partially in the connection regions (31, 32), so that the connection regions (31, 32) are formed at least partially by the housing body (12).

15. Manufacturing method (100) according to any one of the preceding claims,
**characterized in that**
disposing (103) of the printed circuit board (20) in the cavity (11) is carried out through a housing opening (13) of the housing (10), wherein the housing opening (13) is closed with a cover element (14) after disposing (103) the printed circuit board (20) in the cavity (11) and/or that disposing (103) the printed circuit board (20) in the cavity (11) comprises an insertion of the printed circuit board (20) into the cavity (11), wherein the printed circuit board (20) is moved during the insertion in a direction perpendicular to a housing bottom (12.3) of the housing body (12).

16. Manufacturing method (100) according to any one of the preceding claims,
**characterized in that**
the cover element (14) is connected, in particular laser-welded, to the housing body (12) by a material bond.

## Revendications

1. Unité électronique (1) pour un capteur (2), en particulier une pédale, pour un véhicule (3), avec
une première zone de connexion (31) pour connecter l'unité électronique (1) au véhicule (3),
une deuxième zone de connexion (32) pour relier l'unité électronique (1) au capteur (2), un boîtier (10) et une carte de circuit imprimé (20),
dans lequel la carte de circuit imprimé (20) est disposée dans une cavité (11) du boîtier (10),
dans lequel la carte de circuit imprimé (20) est disposée au moins partiellement entre la première zone de connexion (31) et la deuxième zone de connexion (32),
la cavité (11) étant au moins partiellement remplie d'une masse de scellement (15),
la carte de circuit imprimé (20) étant disposée sur au moins un aide de positionnement (18), de sorte que la carte de circuit imprimé (20) est espacée d'un fond de boîtier (12.3).

2. Unité électronique (1) selon la revendication 1,
**caractérisé en ce que**
la cavité (11) du boîtier (10) est formée au moins partiellement par un corps de boîtier (12), en particulier le corps de boîtier (12) présentant une ouverture de boîtier (13) qui est fermée par un élément de couvercle (14) et qui est configurée de telle sorte que la carte de circuit imprimé (20) peut être montée dans la cavité (11) à travers l'ouverture de boîtier (13), en particulier lorsque l'élément de couvercle (14) est enlevé du boîtier (10).

3. Unité électronique (1) selon la revendication 1 ou 2,
**caractérisé en ce que**
l'élément de couvercle (14) est relié au corps de boîtier (12) par une liaison par la matière.

4. Unité électronique (1) selon l'une des revendications précédentes,
**caractérisé en ce qu'**
au moins un élément de liaison (33) s'étend depuis au moins l'une des zones de connexion (31, 32) jusqu'à la carte de circuit imprimé (20) et est relié à la carte de circuit imprimé (20) par liaison de matière, de forme et/ou de force et/ou **en ce que** le boîtier (10) présente un premier section de liaison (16) et/ou un deuxième section de liaison (17) pour recevoir un connecteur enfichable (40).

5. Unité électronique (1) selon la revendication 4,
**caractérisé en ce que**
l'élément de liaison (33) présente une section de pliage (34) en forme de U, en particulier une première branche (34.1) de la section de pliage (34) étant fixée à la carte de circuit imprimé (20) et/ou une deuxième branche (34.2) de la section de pliage (34) étant fixée à la section de liaison (16).

6. Unité électronique (1) selon l'une des revendications précédentes,
**caractérisé en ce que**
plusieurs aides au positionnement (18) sont disposées de telle sorte que, lors d'un montage de la carte de circuit imprimé (20), la carte de circuit imprimé (20) peut être positionnée dans deux orientations au maximum, de préférence dans exactement une orientation.

7. Unité électronique (1) selon l'une des revendications précédentes,
**caractérisé en ce que**
le boîtier (10) présente une matière plastique, et/ou **en ce que** la carte de circuit imprimé (20) comprend un microcontrôleur pour l'évaluation d'un signal de mesure du capteur (2).

8. Unité électronique (1) selon l'une des revendications précédentes,
**caractérisé en ce que**
la carte de circuit imprimé (20) présente au moins une première et une deuxième zone de circuit (21, 22), une communication avec le véhicule (3) pouvant être traitée par la première zone de circuit (21) et des signaux du capteur (2) pouvant être traités par la deuxième zone de circuit (22), en particulier la première zone de circuit (21) présentant une distance plus faible par rapport à la première zone de connexion (31) que la deuxième zone de circuit (22).

9. Unité électronique (1) selon l'une des revendications précédentes,
**caractérisé en ce que**
le boîtier (10) présente au moins une interface de fixation (19) pour la fixation du boîtier (10) sur le véhicule (3), en particulier plusieurs interfaces de fixation (19) étant prévues pour différents concepts de fixation.

10. Unité électronique (1) selon l'une des revendications précédentes,
**caractérisé en ce que**
le corps de boîtier (12) présente une longueur (L) de moins de 150 mm, de préférence de moins de 120 mm, de manière particulièrement préférée de moins de 105 mm, une largeur (B) de moins de 60 mm, de préférence de moins de 50 mm, et/ou une hauteur (H) de moins de 25 mm, de préférence de moins de 20 mm, de manière particulièrement préférée de moins de 15 mm.

11. Véhicule (3) avec une unité électronique (1) selon l'une des revendications précédentes, qui est reliée à une électronique de véhicule (4) et à un capteur (2), en particulier dans lequel l'unité électronique (1) est disposée dans un pare-chocs (3.1) ou une porte latérale (3.2) du véhicule (3).

12. Procédé de fabrication (100) d'une unité électronique (1), selon l'une des revendications 1 à 10, pour un capteur (2) pour un véhicule (3), comprenant les étapes suivantes :
- Former au moins partiellement (102) un boîtier (10) avec une cavité (11) et disposer (101) une première zone de connexion (31) pour connecter l'unité électronique (1) au véhicule (3) sur un premier côté (12.1) du boîtier (10) et une deuxième zone de connexion (32) pour connecter l'unité électronique (1) au capteur (2) sur un deuxième côté (12.2) du boîtier (10),
- mise en place (103) la carte de circuit imprimé (20) entre les première et deuxième zones de connexion (31, 32) dans la cavité (11).

13. Procédé de fabrication (100) selon la revendication 12,
**caractérisé en ce que**
le procédé de fabrication comprend en outre l'étape suivante :
- Remplissage (104) au moins partiel de la cavité (11) avec une masse de scellement (15), en particulier la carte de circuit imprimé (20) étant scellée avec la masse de scellement (15).

14. Procédé de fabrication (100) selon l'une des revendications 12 ou 13,
**caractérisé en ce que**
la disposition (101) de la première et de la deuxième zone de connexion (31, 32) s'effectue au moins partiellement en même temps que la formation au moins partiellement (102) du boîtier (10), un corps de boîtier (12) du boîtier (10) étant formé au moins partiellement dans les zones de connexion (31, 32), de sorte que les zones de connexion (31, 32) sont formées au moins partiellement par le corps de boîtier (12).

15. Procédé de fabrication (100) selon l'une quelconque des revendications précédentes, **caractérisé en ce que**
la mise en place (103) de la carte de circuit imprimé (20) dans la cavité (11) s'effectue à travers une ouverture de boîtier (13) du boîtier (10), l'ouverture de boîtier (13) étant fermée par un élément de couvercle (14) après la mise en place (103) de la carte de circuit imprimé (20) dans la cavité (11) et/ou **en ce que** la mise en place (103) de la carte de circuit imprimé (20) dans la cavité (11) comprend une introduction de la carte de circuit imprimé (20) dans la cavité (11), la carte de circuit imprimé (20) étant introduite pendant l'introduction dans une direction perpendiculaire à un fond de boîtier (12.3) du corps de boîtier (12).

16. Procédé de fabrication (100) selon l'une quelconque des revendications précédentes, **caractérisé en ce que**
l'élément de couvercle (14) est assemblé par liaison de matière avec le corps de boîtier (12), en particulier par soudage au laser.
